# EUROPEAN PATENT APPLICATION

(11) **EP 4 379 779 A1**
(43) Date of publication of application: **05.06.2024**
(21) Application number: 22864511.5
(22) Date of filing: 29.08.2022
(51) Int. Cl.: H01L 21/304, B24B 37/00, C09G 1/02, C09K 3/14

(54) **POLISHING SOLUTION, POLISHING METHOD, COMPONENT MANUFACTURING METHOD, AND SEMICONDUCTOR COMPONENT MANUFACTURING METHOD**

(30) Priority: 31.08.2021 WO PCT/JP2021/031892; 31.08.2021 WO PCT/JP2021/031894; 31.05.2022 JP 2022088818
(71) Applicant: Resonac Corporation, Tokyo 105-7325 (JP)
(72) Inventor: ARATA, Shogo, Minato-ku, Tokyo-7325 (JP); SAKASHITA, Masahiro, Minato-ku, Tokyo-7325 (JP); ICHIGE, Yasuhiro, Minato-ku, Tokyo-7325 (JP); HOSHI, Yousuke, Minato-ku, Tokyo-7325 (JP)
(74) Representative: Hoffmann Eitle
(86) International application number: PCT/JP2022/032452
(87) International publication number: WO 2023/032929

(57) **Abstract**

A polishing liquid for polishing a member to be polished containing a resin, the polishing liquid containing abrasive grains containing cerium oxide and an ether compound having a hydroxy group. A polishing method including polishing a member to be polished containing a resin by using the above-described polishing liquid. A method for manufacturing a component, including obtaining a component by using a polished member polished by the above-described polishing method. A method for manufacturing a semiconductor component, including obtaining a semiconductor component by using a polished member polished by the above-described polishing method.

## Description

### Technical Field

The present disclosure relates to a polishing liquid, a polishing method, a method for manufacturing a component, a method for manufacturing a semiconductor component, and the like.

### Background Art

In the manufacturing steps for electronic devices in recent years, the importance of processing technologies for density increase, micronization, and the like is increasing more and more. CMP (chemical mechanical polishing) technology, which is one of the processing technologies, has become an essential technology for formation of a shallow trench isolation (STI), flattening of a pre-metal insulating material or an interlayer insulating material, formation of a plug or an embedded metal wiring, or the like, in the manufacturing steps for electronic devices. As a polishing liquid used in CMP, a polishing liquid that contains abrasive grains containing cerium oxide is known (see, for example, Patent Literatures 1 and 2 below).

### Citation List

### Patent Literature

Patent Literature 1: Japanese Unexamined Patent Publication No. H10-106994
Patent Literature 2: Japanese Unexamined Patent Publication No. H08-022970

### Summary of Invention

### Technical Problem

For the polishing liquid that can be used in CMP, there is a case where a member to be polished containing a resin is required to be quickly removed by polishing. For such a polishing liquid, it is required to improve a polishing rate for a member to be polished containing a resin.

An object of an aspect of the present disclosure is to provide a polishing liquid capable of improving a polishing rate for a member to be polished containing a resin. An object of another aspect of the present disclosure is to provide a polishing method using the above-described polishing liquid. An object of another aspect of the present disclosure is to provide a method for manufacturing a component using the above-described polishing method. An object of another aspect of the present disclosure is to provide a method for manufacturing a semiconductor component using the above-described polishing method.

### Solution to Problem

The present disclosure relates to the following [1] to [19] and the like in several aspects.
[1] A polishing liquid for polishing a member to be polished containing a resin, the polishing liquid containing abrasive grains containing cerium oxide and an ether compound having a hydroxy group.
[2] The polishing liquid described in [1], in which the ether compound includes an alkoxy alcohol.
[3] The polishing liquid described in [2], in which the ether compound includes an alkoxy alcohol having a molecular weight of less than 200.
[4] The polishing liquid described in [2] or [3], in which the alkoxy alcohol includes a compound having an alkoxy group having 1 to 5 carbon atoms.
[5] The polishing liquid described in any one of [2] to [4], in which the alkoxy alcohol includes 1-propoxy-2-propanol.
[6] The polishing liquid described in any one of [2] to [5], in which the alkoxy alcohol includes 3-methoxy-3-methyl-1-butanol.
[7] The polishing liquid described in any one of [2] to [6], in which a content of the alkoxy alcohol is 0.2 to 0.8% by mass on the basis of the total mass of the polishing liquid.
[8] The polishing liquid described in any one of [1] to [7], in which the ether compound further includes a polyether.
[9] The polishing liquid described in [8], in which the polyether includes polyglycerol.
[10] The polishing liquid described in [8] or [9], in which a content of the polyether is 0.5 to 3% by mass on the basis of the total mass of the polishing liquid.
[11] The polishing liquid described in any one of [1] to [10], in which a content of the abrasive grains is 0.5 to 2% by mass on the basis of the total mass of the polishing liquid.
[12] The polishing liquid described in any one of [1] to [11], further containing an organic acid component.
[13] The polishing liquid described in any one of [1] to [12], further containing at least one selected from the group consisting of an ammonium cation and ammonia.
[14] The polishing liquid described in any one of [1] to [13], in which a pH is 9.00 to 11.00.
[15] A polishing method including polishing a member to be polished containing a resin by using the polishing liquid described in any one of [1] to [14].
[16] The polishing method described in [15], in which the resin includes an epoxy resin.
[17] The polishing method described in [15] or [16], in which the member to be polished further contains particles containing silicon oxide.
[18] A method for manufacturing a component, including obtaining a component by using a polished member polished by the polishing method described in any one of [15] to [17].
[19] A method for manufacturing a semiconductor component, including obtaining a semiconductor component by using a polished member polished by the polishing method described in any one of [15] to [17].

### Advantageous Effects of Invention

According to an aspect of the present disclosure, it is possible to provide a polishing liquid capable of improving a polishing rate for a member to be polished containing a resin. According to another aspect of the present disclosure, it is possible to provide a polishing method using the above-described polishing liquid. According to another aspect of the present disclosure, it is possible to provide a method for manufacturing a component using the above-described polishing method. According to another aspect of the present disclosure, it is possible to provide a method for manufacturing a semiconductor component using the above-described polishing method. According to another aspect of the present disclosure, it is possible to provide an application of a polishing liquid to polishing of a member to be polished containing a resin.

### Brief Description of Drawings

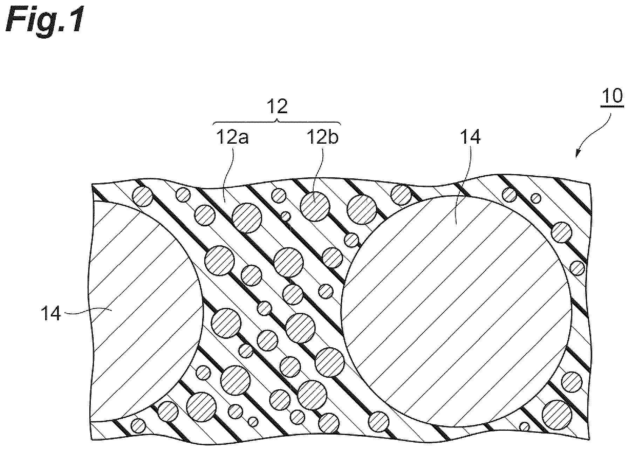

FIG. 1 is a cross-sectional view schematically illustrating an example of a member to be polished.

### Description of Embodiments

Hereinafter, embodiments of the present disclosure will be described. However, the present disclosure is not limited to the following embodiments.

In the present specification, a numerical range that has been indicated by use of "to" indicates the range that includes the numerical values which are described before and after "to", as the minimum value and the maximum value, respectively. "A or more" in the numerical range means A and a range of more than A. "A or less" in the numerical range means A and a range of less than A. In the numerical ranges that are described stepwise in the present specification, the upper limit value or the lower limit value of the numerical range of a certain stage can be arbitrarily combined with the upper limit value or the lower limit value of the numerical range of another stage. In the numerical ranges that are described in the present specification, the upper limit value or the lower limit value of the numerical range may be replaced with the value shown in Examples. "A or B" may include either one of A and B, and may also include both of A and B. Materials listed as examples in the present specification can be used singly or in combinations of two or more, unless otherwise specified. When a plurality of substances corresponding to each component exist in the composition, the content of each component in the composition means the total amount of the plurality of substances that exist in the composition, unless otherwise specified. The term "film" includes a structure having a shape which is formed on a part, in addition to a structure having a shape which is formed on the whole surface, when the film has been observed as a plan view. The term "step" includes not only an independent step but also a step by which an intended action of the step is achieved, though the step cannot be clearly distinguished from other steps. The "alkyl group" may be linear, branched, or cyclic, unless otherwise specified. The term "abrasive grains" means a collective entity of a plurality of particles, and for convenience, one particle constituting the abrasive grains may be referred to as an abrasive grain.

### <Polishing liquid>

A polishing liquid of the present embodiment is a polishing liquid for polishing a member to be polished containing a resin, the polishing liquid containing abrasive grains containing cerium oxide and an ether compound having a hydroxy group (hereinafter, referred to as "ether compound A" in some cases). The polishing liquid of the present embodiment can be used as a CMP polishing liquid.

According to the polishing liquid of the present embodiment, the polishing rate for the member to be polished containing a resin can be improved, and in an evaluation method described in Examples described below, a polishing rate of, for example, more than 0.40 µm/min can be obtained. Examples of the resin include an epoxy resin, a phenol resin, an acrylic resin, a methacrylic resin, a novolak resin, a polyester (unsaturated polyester and a polyester not corresponding to the unsaturated polyester), polyimide, polyamide imide, polyhydroxystyrene, polybenzoxazole (PBO), a precursor of polybenzoxazole, polyallyl ether, and a heterocycle-containing resin (excluding resins exemplified in the above description). Examples of the "heterocycle-containing resin" include a pyrrole-ring-containing resin, a pyridine-ring-containing resin, and an imidazole-ring-containing resin. The member to be polished may contain at least one of these as a main component. The member to be polished may contain at least one selected from the group consisting of an epoxy resin, polyimide, polybenzoxazole, and a precursor of polybenzoxazole.

Although a factor responsible for improving the polishing rate for the member to be polished containing a resin is not necessarily clear, the present inventor has speculated as described below. That is, by using the ether compound having a hydroxy group (ether compound A), the wettability of a surface to be polished in which the resin is present is improved. Furthermore, since the abrasive grains containing cerium oxide is relatively soft, the abrasive grains can efficiently penetrate into the resin without slipping on the resin surface. Thereby, it is speculated that the polishing rate for the member to be polished containing a resin is improved. However, factors responsible for obtaining the effect are not limited to this content.

According to an embodiment of the polishing liquid of the present embodiment, a polishing rate for a metallic material can also be improved. Examples of metals of the metallic material include copper, cobalt, tantalum, aluminum, titanium, tungsten, and manganese. Examples of the metallic material include wiring materials and barrier metallic materials. Examples of the metallic material include copper-based metals (such as metallic copper (elemental metal) and a copper compound), cobalt-based metals (such as metallic cobalt (elemental metal)), tantalum-based metals (such as metallic tantalum (elemental metal) and tantalum nitride), aluminum-based metals (such as metallic aluminum (elemental metal)), titanium-based metals (such as metallic titanium (elemental metal) and titanium nitride), tungsten-based metals (such as metallic tungsten (elemental metal)), and manganese-based metals (such as metallic manganese (elemental metal)). According to an embodiment of the polishing liquid of the present embodiment, in evaluation described in Examples described below, a polishing rate for copper of, for example, 0.05 µm/min or more (preferably 0.35 µm/min or more) can be obtained.

In recent years, from the viewpoint of an increase in speed, power consumption reduction, an increase in capacity, and the like of electronic devices, 2.1D integrated circuits, 2.5D integrated circuits, 3D integrated circuits, and the like have been developed, and there is an increased interest in connecting processes such as chip-to-chip, wafer-to-wafer, and chip-to-wafer, and semiconductor package manufacturing processes using WLP (Wafer-Level Packaging), PLP (Panel-Level Packaging), and the like. In the surface to be polished of the member to be polished required to be flattened for obtaining a favorable connection surface (here, not only a surface to be directly connected but also a surface to become a base in the case of being connected through another member are referred to as the "connection surface") in these processes, a resin (for example, an epoxy resin) and a metallic material (for example, a copper-based metal) may be present. For example, the member to be polished may have a base material portion containing a resin, and a metal portion disposed in an opening (an opening extending in a thickness direction of the member to be polished (the thickness direction of the base material portion)) formed in the base material portion and containing a metallic material. Furthermore, the member to be polished may have a metal portion extending in a thickness direction of the member to be polished (thickness direction of a base material portion) and containing a metallic material, and a base material portion (base material portion containing a resin) covering at least a part (part or all) of the outer periphery of the metal portion. The member to be polished may have at least one (for example, a plurality of) metal portion. The member to be polished may be obtained by supplying the constituent material for the metal portion to the opening formed in the base material portion, and may be obtained by supplying the constituent material for the base material portion so as to cover at least a part of the outer periphery of the metal portion.

According to an embodiment of the polishing liquid of the present embodiment, as the polishing liquid used for polishing a member to be polished containing a resin (for example, an epoxy resin) and a metallic material (for example, copper-based metal), it is possible to improve the polishing rate for the member to be polished containing a resin and a metallic material, and for example, it is possible to improve the polishing rate for the surface to be polished in which the resin and the metallic material are present in the aforementioned member to be polished having the base material portion and the metal portion. According to such a polishing liquid, the aforementioned surface to be polished in which the resin and the metallic material are present can be suitably smoothed.

Furthermore, there is a case where a resin (for example, an epoxy resin) and a silicon compound (a compound containing silicon; for example, silicon oxide) are present in the surface to be polished of the member to be polished. For example, there is a case where a resin, a silicon compound, and a metallic material are present in the surface to be polished when the base material portion in the aforementioned member to be polished having the base material portion and the metal portion contains particles containing a silicon compound. On the other hand, according to an embodiment of the polishing liquid of the present embodiment, as the polishing liquid used for polishing a member to be polished containing a resin (for example, an epoxy resin) and a silicon compound (for example, silicon oxide), it is possible to improve the polishing rate for the member to be polished containing a resin and a silicon compound, and for example, it is possible to improve the polishing rate for the surface to be polished in which the resin, the silicon compound, and the metallic material are present in the aforementioned member to be polished having the base material portion and the metal portion. According to such a polishing liquid, the aforementioned surface to be polished in which the resin, the silicon compound, and the metallic material are present can be suitably smoothed.

FIG. 1 is a cross-sectional view schematically illustrating an example of a member to be polished, and illustrates a cross-section parallel to a surface to be polished. A member to be polished 10 illustrated in FIG. 1 has a base material portion 12 and a metal portion 14 disposed in an opening formed in the base material portion 12, and the base material portion 12 contains a resin 12a and particles 12b containing a silicon compound. However, the dimensions and number of respective members (the particles 12b, the metal portion 14, and the like), the dimensional ratio between members, and the like are not limited to the contents illustrated in the drawing.

Examples of the silicon compound include silicon oxide (for example, SiO₂), SiOC, and silicon nitride (for example, SiN). The particles containing a silicon compound may contain silicon oxide. In a cross-section of the member to be polished containing a resin and particles containing a silicon compound, the short diameter of the particle, or the ratio (basis: entire cross-section) of the area occupied by the particles may be in the following range. The short diameter of the particle may be 0.01 µm or more, 0.2 µm or more, 0.6 µm or more, or 1.0 µm or more. The short diameter of the particle may be 100 µm or less, 50 µm or less, 25 µm or less, or 15 µm or less. From these viewpoints, the short diameter of the particle may be 0.01 to 100 µm. The area ratio may be 1% or more, 15% or more, 30% or more, 45% or more, or 60% or more. The area ratio may be 99% or less, 90% or less, 80% or less, or 70% or less. From these viewpoints, the area ratio may be 1 to 99%. The cross-sectional shape of the metal portion perpendicular to the thickness direction of the base material portion may be circular, and the diameter of the metal portion may be 1 to 200 µm. A spacing between adjacent metal portions may be 1 to 200 µm.

The polishing liquid of the present embodiment contains abrasive grains containing cerium oxide. By using the abrasive grains containing cerium oxide, the polishing rate for the member to be polished containing a resin can be improved, and the polishing rate for the member to be polished containing a resin and a metallic material and the polishing rate for the member to be polished containing a resin and a silicon compound are easily improved. The abrasive grains may include one or more types of particles. Examples of the constituent material for the abrasive grains other than the cerium oxide include inorganic materials such as silica (SiO₂), alumina, zirconia, titania, germania, and silicon carbide. The polishing liquid of the present embodiment may not contain alumina as the constituent material of the abrasive grains and the like. The content of the alumina may be 0.1% by mass or less, less than 0.1% by mass, 0.01% by mass or less, 0.001% by mass or less, or substantially 0% by mass, on the basis of the total mass of the polishing liquid.

The content of the cerium oxide in the abrasive grains may be 90% by mass or more, 93% by mass or more, 95% by mass or more, more than 95% by mass, 98% by mass or more, 99% by mass or more, 99.5% by mass or more, or 99.9% by mass or more, on the basis of the whole abrasive grains (the whole abrasive grains contained in the polishing liquid, or the whole of one particle constituting the abrasive grains), from the viewpoint of easily improving the polishing rate for the member to be polished containing a resin and the polishing rate for the metallic material. The abrasive grains may be an embodiment substantially composed of cerium oxide (an embodiment in which substantially 100% by mass of the abrasive grains are cerium oxide).

The average particle diameter D50 or D80 of the abrasive grains may be in the following range. The average particle diameters D50 and D80 of the abrasive grains mean 50% particle diameter and 80% particle diameter in a volume-based cumulative distribution, and can be measured, for example, by a laser diffraction type particle size distribution analyzer. The average particle diameter of the abrasive grains can be adjusted by spontaneous precipitation, a pulverization treatment, dispersion, filtration, or the like, and for example, the particle diameter adjustment may be performed after the constituent components of the polishing liquid are mixed.

The average particle diameter D50 of the abrasive grains may be 10 nm or more, 50 nm or more, 70 nm or more, 100 nm or more, 150 nm or more, more than 150 nm, 200 nm or more, 250 nm or more, 300 nm or more, 320 nm or more, or 340 nm or more, from the viewpoint of easily improving the polishing rate for the member to be polished containing a resin and the polishing rate for the metallic material. The average particle diameter D50 of the abrasive grains may be 1000 nm or less, 800 nm or less, 600 nm or less, 500 nm or less, 450 nm or less, 400 nm or less, or 350 nm or less, from the viewpoint of easily suppressing polishing scratches. From these viewpoints, the average particle diameter D50 of the abrasive grains may be 10 to 1000 nm, 50 to 800 nm, 100 to 500 nm, or 200 to 400 nm.

The average particle diameter D80 of the abrasive grains may be 50 nm or more, 100 nm or more, 200 nm or more, 300 nm or more, 350 nm or more, 400 nm or more, 450 nm or more, 500 nm or more, 550 nm or more, or 600 nm or more, from the viewpoint of easily improving the polishing rate for the member to be polished containing a resin and the polishing rate for the metallic material. The average particle diameter D80 of the abrasive grains may be 1200 nm or less, 1100 nm or less, 1000 nm or less, 900 nm or less, 800 nm or less, 750 nm or less, 700 nm or less, or 650 nm or less, from the viewpoint of easily suppressing polishing scratches. From these viewpoints, the average particle diameter D80 of the abrasive grains may be 50 to 1200 nm, 100 to 1000 nm, 300 to 800 nm, or 500 to 700 nm.

The content of the abrasive grains may be in the following range on the basis of the total mass of the polishing liquid. The content of the abrasive grains may be 0.01% by mass or more, 0.05% by mass or more, 0.1% by mass or more, 0.3% by mass or more, 0.5% by mass or more, more than 0.5% by mass, 0.7% by mass or more, 0.8% by mass or more, 0.9% by mass or more, 1% by mass or more, 1.5% by mass or more, or 2% by mass or more, from the viewpoint of easily improving the polishing rate for the member to be polished containing a resin and the polishing rate for the metallic material. The content of the abrasive grains may be 10% by mass or less, 8% by mass or less, 5% by mass or less, 4% by mass or less, 3% by mass or less, 2% by mass or less, 1.5% by mass or less, or 1% by mass or less, from the viewpoint of easily avoiding an increase in the viscosity of the polishing liquid, the aggregation of the abrasive grains, and the like. From these viewpoints, the content of the abrasive grains may be 0.01 to 10% by mass, 0.1 to 5% by mass, 0.5 to 2% by mass, or 0.5 to 1.5% by mass.

The polishing liquid of the present embodiment contains an ether compound (ether compound A) having a hydroxy group. The ether compound having a hydroxy group is a compound having at least one hydroxy group and at least one ether group. The "ether group" in the ether compound A does not include the "-O-" structure in a hydroxy group (hydroxyl group), a carboxy group, a carboxylate group, an ester group, a sulfo group, and a phosphoric acid group. The hydroxy group does not include the OH group contained in a carboxy group, a sulfo group, and a phosphoric acid group.

The ether compound A may include a compound having the number of hydroxy groups in the following range from the viewpoint of easily improving the polishing rate for the member to be polished containing a resin and the polishing rate for the metallic material. The number of hydroxy groups is 1 or more, and may be 2 or more, 3 or more, 4 or more, 5 or more, 6 or more, 8 or more, 9 or more, 10 or more, 11 or more, or 12 or more. The number of hydroxy groups may be 20 or less, 15 or less, 12 or less, 11 or less, 10 or less, 9 or less, 8 or less, 6 or less, 5 or less, 4 or less, 3 or less, or 2 or less. From these viewpoints, the number of hydroxy groups may be 1 to 20, 1 to 10, 1 to 5, 1 to 3, or 1 to 2. From the viewpoint of easily improving the polishing rate for the member to be polished containing a resin and the polishing rate for the metallic material, the ether compound A may include a compound having one hydroxy group, may include a compound having two or more hydroxy groups, and may include a compound having one hydroxy group and a compound having two or more hydroxy groups.

The ether compound A may include a compound having the number of ether groups in the following range from the viewpoint of easily improving the polishing rate for the member to be polished containing a resin and the polishing rate for the metallic material. The number of ether groups is 1 or more, and may be 2 or more, 3 or more, 4 or more, 5 or more, 6 or more, 8 or more, or 9 or more. The number of ether groups may be 20 or less, 15 or less, 12 or less, 11 or less, 10 or less, 9 or less, 8 or less, 6 or less, 5 or less, 4 or less, 3 or less, or 2 or less. From these viewpoints, the number of ether groups may be 1 to 20, 1 to 10, 1 to 5, 1 to 3, or 1 to 2. From the viewpoint of easily improving the polishing rate for the member to be polished containing a resin and the polishing rate for the metallic material, the ether compound A may include a compound having one ether group, may include a compound having two or more ether groups, and may include a compound having one ether group and a compound having two or more ether groups.

The ether compound A may include an alkoxy alcohol from the viewpoint of easily improving the polishing rate for the member to be polished containing a resin and the polishing rate for the metallic material. Examples of the alkoxy alcohol include 2-methoxyethanol, 2-ethoxyethanol, 2-(2-methoxy)ethoxyethanol, 2-(2-butoxyethoxy)ethanol, 2-propoxyethanol, 2-butoxyethanol, 3-methoxy-3-methyl-1-butanol, 2-(methoxymethoxy)ethanol, 2-isopropoxyethanol, 2-butoxyethanol, 2-isopentyloxyethanol, 1-propoxy-2-propanol, 3-methoxy-3-methyl-1-butanol, 3-methoxy-1-butanol, 3-methoxy-3-methylbutanol, 1-methoxy-2-butanol, and glycol monoether. The alkoxy alcohol may include a compound having an alkoxy group having 1 to 5, 1 to 4, 1 to 3, 1 to 2, or 2 to 3 carbon atoms from the viewpoint of easily improving the polishing rate for the member to be polished containing a resin and the polishing rate for the metallic material. From the viewpoint of easily improving the polishing rate for the member to be polished containing a resin and the polishing rate for the metallic material, the alkoxy alcohol may include 1-propoxy-2-propanol and may include 3-methoxy-3-methyl-1-butanol.

From the viewpoint of easily improving the polishing rate for the member to be polished containing a resin and the polishing rate for the metallic material, the ether compound A may include a polyether and may include an alkoxy alcohol and a polyether. Examples of the polyether include polyglycerol, polysaccharide, polyalkylene glycol, polyoxypropylene polyglyceryl ether, polyoxyethylene polyglyceryl ether, 1,4-di(2-hydroxyethoxy)benzene, 2,2-bis(4-polyoxyethyleneoxyphenyl)propane, 2,2-bis(4-polyoxypropyleneoxyphenyl)propane, ethylene glycol monophenyl ether, diethylene glycol monophenyl ether, polyoxyalkylene monophenyl ether, propylene glycol monophenyl ether, polyoxypropylene monomethyl phenyl ether, polyethylene glycol monomethyl ether, pentaerythritol polyoxyethylene ether, ethylene glycol monoallyl ether, polyoxyethylene monoallyl ether, and alkyl glucoside. As the polyether, a compound different from the alkoxy alcohol may be used. The polyether may include polyglycerol from the viewpoint of easily improving the polishing rate for the member to be polished containing a resin and the polishing rate for the metallic material.

The ether compound A may include polyglycerol having an average degree of polymerization of glycerol in the following range from the viewpoint of easily improving the polishing rate for the member to be polished containing a resin and the polishing rate for the metallic material. The average degree of polymerization may be 3 or more, 4 or more, 5 or more, 8 or more, or 10 or more. The average degree of polymerization may be 100 or less, 50 or less, 30 or less, 20 or less, 15 or less, 12 or less, or 10 or less. From these viewpoints, the average degree of polymerization may be 3 to 100, 5 to 50, 8 to 20, 5 to 15, or 8 to 15.

The ether compound A may include polyglycerol having a hydroxyl value in the following range from the viewpoint of easily improving the polishing rate for the member to be polished containing a resin and the polishing rate for the metallic material. The hydroxyl value may be 100 or more, 200 or more, 300 or more, 400 or more, 500 or more, 600 or more, 700 or more, 800 or more, 850 or more, or 870 or more. The hydroxyl value may be 2000 or less, 1500 or less, 1200 or less, 1100 or less, 1000 or less, 950 or less, 930 or less, or 910 or less. From these viewpoints, the hydroxyl value may be 100 to 2000, 300 to 1500, 500 to 1200, or 800 to 1000.

The ether compound A may include a compound having one hydroxy group and one ether group from the viewpoint of easily improving the polishing rate for the member to be polished containing a resin and the polishing rate for the metallic material. From the viewpoint of easily improving the polishing rate for the member to be polished containing a resin and the polishing rate for the metallic material, the ether compound A may include a compound having an ether group binding an alkyl group having a hydroxy group as a substituent and an unsubstituted alkyl group to each other, and this compound may be a compound having one hydroxy group and one ether group.

The ether compound A may include a compound having the following molecular weight from the viewpoint of easily improving the polishing rate for the member to be polished containing a resin and the polishing rate for the metallic material. The molecular weight may be 50 or more, 80 or more, 100 or more, 110 or more, 115 or more, 118 or more, 120 or more, 150 or more, 190 or more, 200 or more, more than 200, 300 or more, 500 or more, 700 or more, or 750 or more. The molecular weight may be 3000 or less, 2000 or less, 1500 or less, 1200 or less, 1000 or less, 800 or less, 750 or less, 700 or less, 500 or less, 300 or less, 200 or less, less than 200, 190 or less, 150 or less, or 120 or less. From these viewpoints, the molecular weight may be 50 to 3000, 80 to 1000, 100 to 500, 100 to 200, or 100 or more and less than 200. The ether compound A may include, for example, an alkoxy alcohol having a molecular weight of less than 200.

In a case where the ether compound A is a polymer, the weight average molecular weight (Mw) may be used as the aforementioned molecular weight. The weight average molecular weight can be measured, for example, using gel permeation chromatography (GPC) under the following conditions.

### [Conditions]

Sample: 20 µL
Standard polyethylene glycol: Standard polyethylene glycol (molecular weight: 106, 194, 440, 600, 1470, 4100, 7100, 10300, 12600, and 23000) manufactured by Polymer Laboratories Co., Ltd.
Detector: RI-monitor, trade name "Syodex-RI SE-61" manufactured by Showa Denko K.K.
Pump: trade name "L-6000" manufactured by Hitachi, Ltd.
Column: trade names "GS-220HQ" and "GS-620HQ" manufactured by Showa Denko K.K. are connected in this order and used.
Eluent: 0.4 mol/L sodium chloride aqueous solution
Measurement temperature: 30°C
Flow rate: 1.00 mL/min
Measurement time: 45 min

The content of the alkoxy alcohol may be in the following range on the basis of the total mass of an ether compound (the total mass of an ether compound contained in the polishing liquid) or the total mass of the ether compound A (the total mass of the ether compound A contained in the polishing liquid), from the viewpoint of easily improving the polishing rate for the member to be polished containing a resin and the polishing rate for the metallic material. The content of the alkoxy alcohol may be more than 0% by mass, 5% by mass or more, 8% by mass or more, 10% by mass or more, 12% by mass or more, 15% by mass or more, 18% by mass or more, 20% by mass or more, 23% by mass or more, 24% by mass or more, 25% by mass or more, 30% by mass or more, 35% by mass or more, 40% by mass or more, 45% by mass or more, 50% by mass or more, more than 50% by mass, 55% by mass or more, 60% by mass or more, 65% by mass or more, 70% by mass or more, 75% by mass or more, 80% by mass or more, 85% by mass or more, 90% by mass or more, or 95% by mass or more. The content of the alkoxy alcohol may be 100% by mass or less, less than 100% by mass, 95% by mass or less, 90% by mass or less, 85% by mass or less, 80% by mass or less, 75% by mass or less, 70% by mass or less, 65% by mass or less, 60% by mass or less, 55% by mass or less, 50% by mass or less, less than 50% by mass, 45% by mass or less, 40% by mass or less, 35% by mass or less, 30% by mass or less, 25% by mass or less, or 24% by mass or less. From these viewpoints, the content of the alkoxy alcohol may be more than 0% by mass and 100% by mass or less, 5 to 100% by mass, 5 to 95% by mass, 5 to 50% by mass, 5 to 40% by mass, 20 to 100% by mass, 20 to 95% by mass, 20 to 50% by mass, or 20 to 40% by mass.

As the content of the polyether or the content of polyglycerol, a content A may be in the following range on the basis of the total mass of an ether compound (the total mass of an ether compound contained in the polishing liquid) or the total mass of the ether compound A (the total mass of the ether compound A contained in the polishing liquid), from the viewpoint of easily improving the polishing rate for the member to be polished containing a resin and the polishing rate for the metallic material. The content A may be more than 0% by mass, 5% by mass or more, 10% by mass or more, 15% by mass or more, 20% by mass or more, 25% by mass or more, 30% by mass or more, 35% by mass or more, 40% by mass or more, 45% by mass or more, 50% by mass or more, more than 50% by mass, 55% by mass or more, 60% by mass or more, 65% by mass or more, 70% by mass or more, 75% by mass or more, or 76% by mass or more. The content A may be 100% by mass or less, less than 100% by mass, 95% by mass or less, 92% by mass or less, 90% by mass or less, 88% by mass or less, 85% by mass or less, 82% by mass or less, 80% by mass or less, 77% by mass or less, 76% by mass or less, 75% by mass or less, 70% by mass or less, or 65% by mass or less. From these viewpoints, the content A may be more than 0% by mass and 100% by mass or less, more than 0% by mass and 95% by mass or less, 5 to 95% by mass, 50 to 95% by mass, 60 to 95% by mass, more than 0% by mass and 80% by mass or less, 5 to 80% by mass, 50 to 80% by mass, or 60 to 80% by mass.

The content of the ether compound A may be in the following range on the basis of the total mass of the polishing liquid from the viewpoint of easily improving the polishing rate for the member to be polished containing a resin and the polishing rate for the metallic material. The content of the ether compound A may be more than 0% by mass, 0.01 % by mass or more, 0.03% by mass or more, 0.05% by mass or more, 0.08% by mass or more, 0.1% by mass or more, 0.3% by mass or more, 0.5% by mass or more, 0.8% by mass or more, 1% by mass or more, more than 1% by mass, 1.1% by mass or more, 1.2% by mass or more, 1.3% by mass or more, 1.4% by mass or more, 1.5% by mass or more, or 1.6% by mass or more. The content of the ether compound A may be 10% by mass or less, 8% by mass or less, 5% by mass or less, 3% by mass or less, 2% by mass or less, 1.8% by mass or less, 1.7% by mass or less, 1.6% by mass or less, 1.5% by mass or less, 1.4% by mass or less, 1.3% by mass or less, 1.2% by mass or less, 1.1% by mass or less, 1% by mass or less, less than 1% by mass, 0.8% by mass or less, 0.5% by mass or less, 0.3% by mass or less, or 0.1% by mass or less. From these viewpoints, the content of the ether compound A may be more than 0% by mass and 10% by mass or less, 0.1 to 10% by mass, 0.5 to 10% by mass, 1 to 10% by mass, more than 0% by mass and 5% by mass or less, 0.1 to 5% by mass, 0.5 to 5% by mass, 1 to 5% by mass, more than 0% by mass and 3% by mass or less, 0.1 to 3% by mass, 0.5 to 3% by mass, or 1 to 3% by mass.

The content of the alkoxy alcohol may be in the following range on the basis of the total mass of the polishing liquid from the viewpoint of easily improving the polishing rate for the member to be polished containing a resin and the polishing rate for the metallic material. The content of the alkoxy alcohol may be more than 0% by mass, 0.01% by mass or more, 0.03% by mass or more, 0.05% by mass or more, 0.08% by mass or more, 0.1% by mass or more, 0.15% by mass or more, 0.2% by mass or more, 0.25% by mass or more, 0.3% by mass or more, 0.31% by mass or more, 0.33% by mass or more, 0.35% by mass or more, 0.4% by mass or more, 0.45% by mass or more, 0.5% by mass or more, 0.55% by mass or more, 0.6% by mass or more, or 0.65% by mass or more. The content of the alkoxy alcohol may be 5% by mass or less, 3% by mass or less, 1% by mass or less, 0.8% by mass or less, 0.7% by mass or less, 0.65% by mass or less, 0.6% by mass or less, 0.55% by mass or less, 0.5% by mass or less, 0.45% by mass or less, 0.4% by mass or less, 0.35% by mass or less, 0.33% by mass or less, 0.31% by mass or less, 0.3% by mass or less, 0.25% by mass or less, 0.2% by mass or less, 0.15% by mass or less, or 0.1% by mass or less. From these viewpoints, the content of the alkoxy alcohol may be more than 0% by mass and 5% by mass or less, 0.01 to 5% by mass, 0.1 to 5% by mass, 0.2 to 5% by mass, more than 0% by mass and 1% by mass or less, 0.01 to 1% by mass, 0.1 to 1% by mass, 0.2 to 1% by mass, more than 0% by mass and 0.8% by mass or less, 0.01 to 0.8% by mass, 0.1 to 0.8% by mass, 0.2 to 0.8% by mass, more than 0% by mass and 0.5% by mass or less, 0.01 to 0.5% by mass, 0.1 to 0.5% by mass, or 0.2 to 0.5% by mass.

As the content of the polyether or the content of polyglycerol, a content B may be in the following range on the basis of the total mass of the polishing liquid from the viewpoint of easily improving the polishing rate for the member to be polished containing a resin and the polishing rate for the metallic material. The content B may be more than 0% by mass, 0.01% by mass or more, 0.05% by mass or more, 0.1% by mass or more, 0.3% by mass or more, 0.5% by mass or more, 0.6% by mass or more, 0.8% by mass or more, 0.9% by mass or more, or 1% by mass or more. The content B may be 10% by mass or less, 8% by mass or less, 7% by mass or less, 6% by mass or less, 5% by mass or less, 4% by mass or less, 3% by mass or less, 2% by mass or less, 1.5% by mass or less, or 1% by mass or less. From these viewpoints, the content B may be more than 0% by mass and 10% by mass or less, 0.01 to 10% by mass, 0.1 to 5% by mass, 0.5 to 3% by mass, or 0.5 to 2% by mass.

The content of the ether compound A may be in the following range with respect to 100 parts by mass of the abrasive grains from the viewpoint of easily improving the polishing rate for the member to be polished containing a resin and the polishing rate for the metallic material. The content of the ether compound A may be more than 0 parts by mass, 1 part by mass or more, 3 parts by mass or more, 5 parts by mass or more, 8 parts by mass or more, 10 parts by mass or more, 30 parts by mass or more, 50 parts by mass or more, 80 parts by mass or more, 100 parts by mass or more, more than 100 parts by mass, 110 parts by mass or more, 120 parts by mass or more, 130 parts by mass or more, 140 parts by mass or more, 150 parts by mass or more, or 160 parts by mass or more. The content of the ether compound A may be 1000 parts by mass or less, 800 parts by mass or less, 500 parts by mass or less, 300 parts by mass or less, 200 parts by mass or less, 180 parts by mass or less, 170 parts by mass or less, 160 parts by mass or less, 150 parts by mass or less, 140 parts by mass or less, 130 parts by mass or less, 120 parts by mass or less, 110 parts by mass or less, 100 parts by mass or less, less than 100 parts by mass, 80 parts by mass or less, 50 parts by mass or less, 30 parts by mass or less, 10 parts by mass or less, 8 parts by mass or less, or 5 parts by mass or less. From these viewpoints, the content of the ether compound A may be more than 0 parts by mass and 1000 parts by mass or less, 10 to 1000 parts by mass, 50 to 1000 parts by mass, 100 to 1000 parts by mass, more than 0 parts by mass and 500 parts by mass or less, 10 to 500 parts by mass, 50 to 500 parts by mass, 100 to 500 parts by mass, more than 0 parts by mass and 300 parts by mass or less, 10 to 300 parts by mass, 50 to 300 parts by mass, or 100 to 300 parts by mass.

The content of the alkoxy alcohol may be in the following range with respect to 100 parts by mass of the abrasive grains from the viewpoint of easily improving the polishing rate for the member to be polished containing a resin and the polishing rate for the metallic material. The content of the alkoxy alcohol may be more than 0 parts by mass, 1 part by mass or more, 3 parts by mass or more, 5 parts by mass or more, 8 parts by mass or more, 10 parts by mass or more, 15 parts by mass or more, 20 parts by mass or more, 25 parts by mass or more, 30 parts by mass or more, 35 parts by mass or more, 40 parts by mass or more, 45 parts by mass or more, 50 parts by mass or more, 55 parts by mass or more, 60 parts by mass or more, or 65 parts by mass or more. The content of the alkoxy alcohol may be 500 parts by mass or less, 300 parts by mass or less, 100 parts by mass or less, 80 parts by mass or less, 70 parts by mass or less, 65 parts by mass or less, 60 parts by mass or less, 55 parts by mass or less, 50 parts by mass or less, 45 parts by mass or less, 40 parts by mass or less, 35 parts by mass or less, 30 parts by mass or less, 25 parts by mass or less, 20 parts by mass or less, 15 parts by mass or less, 10 parts by mass or less, 8 parts by mass or less, or 5 parts by mass or less. From these viewpoints, the content of the alkoxy alcohol may be more than 0 parts by mass and 500 parts by mass or less, 1 to 500 parts by mass, 10 to 500 parts by mass, 20 to 500 parts by mass, more than 0 parts by mass and 100 parts by mass or less, 1 to 100 parts by mass, 10 to 100 parts by mass, 20 to 100 parts by mass, more than 0 parts by mass and 80 parts by mass or less, 1 to 80 parts by mass, 10 to 80 parts by mass, 20 to 80 parts by mass, more than 0 parts by mass and 50 parts by mass or less, 1 to 50 parts by mass, 10 to 50 parts by mass, or 20 to 50 parts by mass.

As the content of the polyether or the content of polyglycerol, a content C may be in the following range with respect to 100 parts by mass of the abrasive grains from the viewpoint of easily improving the polishing rate for the member to be polished containing a resin and the polishing rate for the metallic material. The content C may be more than 0 parts by mass, 1 part by mass or more, 5 parts by mass or more, 10 parts by mass or more, 30 parts by mass or more, 50 parts by mass or more, 60 parts by mass or more, 80 parts by mass or more, 90 parts by mass or more, or 100 parts by mass or more. The content C may be 1000 parts by mass or less, 800 parts by mass or less, 700 parts by mass or less, 600 parts by mass or less, 500 parts by mass or less, 400 parts by mass or less, 300 parts by mass or less, 200 parts by mass or less, 150 parts by mass or less, or 100 parts by mass or less. From these viewpoints, the content C may be more than 0 parts by mass and 1000 parts by mass or less, 1 to 1000 parts by mass, 10 to 500 parts by mass, 50 to 300 parts by mass, or 50 to 200 parts by mass.

The content of the alkoxy alcohol may be in the following range with respect to 100 parts by mass of polyether or 100 parts by mass of polyglycerol from the viewpoint of easily improving the polishing rate for the member to be polished containing a resin and the polishing rate for the metallic material. The content of the alkoxy alcohol may be more than 0 parts by mass, 1 part by mass or more, 3 parts by mass or more, 5 parts by mass or more, 8 parts by mass or more, 10 parts by mass or more, 15 parts by mass or more, 20 parts by mass or more, 25 parts by mass or more, 30 parts by mass or more, 32 parts by mass or more, 33 parts by mass or more, 34 parts by mass or more, 35 parts by mass or more, 40 parts by mass or more, 45 parts by mass or more, 50 parts by mass or more, 55 parts by mass or more, 60 parts by mass or more, or 65 parts by mass or more. The content of the alkoxy alcohol may be 1000 parts by mass or less, 800 parts by mass or less, 700 parts by mass or less, 600 parts by mass or less, 500 parts by mass or less, 400 parts by mass or less, 300 parts by mass or less, 200 parts by mass or less, 150 parts by mass or less, 120 parts by mass or less, 100 parts by mass or less, 80 parts by mass or less, 70 parts by mass or less, 65 parts by mass or less, 60 parts by mass or less, 55 parts by mass or less, 50 parts by mass or less, 45 parts by mass or less, 40 parts by mass or less, 35 parts by mass or less, 34 parts by mass or less, 33 parts by mass or less, or 32 parts by mass or less. From these viewpoints, the content of the alkoxy alcohol may be more than 0 parts by mass and 1000 parts by mass or less, 1 to 1000 parts by mass, 10 to 1000 parts by mass, more than 0 parts by mass and 100 parts by mass or less, 1 to 100 parts by mass, 10 to 100 parts by mass, more than 0 parts by mass and 50 parts by mass or less, 1 to 50 parts by mass, or 10 to 50 parts by mass.

The polishing liquid of the present embodiment may not contain xanthan gum as the ether compound A. The content of the xanthan gum may be 0.5% by mass or less, less than 0.5% by mass, 0.1% by mass or less, 0.01% by mass or less, or substantially 0% by mass, on the basis of the total mass of the polishing liquid.

### (Water)

The polishing liquid of the present embodiment may contain water. Water may be contained as a residue excluding other constituent components from the polishing liquid. The content of the water may be in the following range on the basis of the total mass of the polishing liquid. The content of the water may be 90% by mass or more, 91% by mass or more, 92% by mass or more, 93% by mass or more, 94% by mass or more, 94.5% by mass or more, 95% by mass or more, 95.5% by mass or more, 96% by mass or more, or 97% by mass or more. The content of the water may be less than 100% by mass, 99% by mass or less, 98% by mass or less, 97% by mass or less, 96% by mass or less, or 95.5% by mass or less. From these viewpoints, the content of the water may be 90% by mass or more and less than 100% by mass, 90 to 99% by mass, or 95 to 99% by mass.

### (Additive)

The polishing liquid of the present embodiment may contain a component other than the abrasive grains, the ether compound A, and water. Examples of such a component include an ether compound not having a hydroxy group, an acid component, ammonia, an anticorrosive agent, a basic hydroxide, a peroxide, an organic solvent, a surfactant, and an antifoaming agent. The polishing liquid of the present embodiment may not contain at least one of these components.

The polishing liquid of the present embodiment may contain an acid component. It is speculated that the polishing rate for the metallic material is easily improved by the acid component forming a complex with the metallic material, the acid component dissolving the metallic material, and the like. The polishing liquid of the present embodiment may contain an organic acid component and may contain an inorganic acid component, as an acid component.

Examples of the organic acid component include organic acids (excluding amino acid), organic acid esters, organic acid salts, amino acids, amino acid esters, and amino acid salts. Examples of the organic acids include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, 3-methylphthalic acid, 4-methylphthalic acid, 3-aminophthalic acid, 4-aminophthalic acid, 3-nitrophthalic acid, 4-nitrophthalic acid, glutaric acid, adipic acid, pimelic acid, maleic acid, phthalic acid, isophthalic acid, malic acid, tartaric acid, citric acid, p-toluenesulfonic acid, p-phenolsulfonic acid, methylsulfonic acid, lactic acid, itaconic acid, maleic acid, quinaldic acid, adipic acid, and pimelic acid. Examples of the organic acid esters include esters of the aforementioned organic acids. Examples of the organic acid salts include ammonium salts (for example, ammonium acetate), alkali metal salts, alkaline earth metal salts and halides of the aforementioned organic acids. Examples of the amino acids include alanine, arginine, asparagine, aspartic acid, cysteine, glutamine, glutamic acid, glycine, histidine, isoleucine, leucine, lysine, methionine, phenylalanine, proline, serine, threonine, tryptophan, tyrosine and valine. Examples of the amino acid esters include esters of the aforementioned amino acids. Examples of the amino acid salts include alkali metal salts of the aforementioned organic acids.

Examples of the inorganic acid component include inorganic acids, ammonium salts of inorganic acids, and metal salts (such as alkali metal salts and alkaline earth metal salts) of inorganic acids. Examples of the inorganic acids include hydrochloric acid, sulfuric acid, nitric acid, and chromic acid. Examples of the ammonium salts of inorganic acids include ammonium salts of monovalent inorganic acids such as ammonium nitrate, ammonium chloride, and ammonium bromide; ammonium salts of divalent inorganic acids such as ammonium carbonate, ammonium hydrogen carbonate, ammonium sulfate, ammonium persulfate, and diammonium cerium nitrate; and ammonium salts of trivalent inorganic acids such as ammonium phosphate, ammonium hydrogen phosphate, ammonium dihydrogen phosphate, and ammonium borate.

From the viewpoint of easily improving the polishing rate for the metallic material, the organic acid component may include at least one selected from the group consisting of an organic acid different from an amino acid and an amino acid, and may include at least one selected from the group consisting of malic acid and glycine. From the viewpoint of easily improving the polishing rate for the metallic material, the inorganic acid component may include at least one selected from the group consisting of ammonium chloride, ammonium carbonate, ammonium hydrogen carbonate, ammonium sulfate, ammonium persulfate, and ammonium dihydrogen phosphate, may include at least one selected from the group consisting of ammonium carbonate, ammonium hydrogen carbonate, ammonium persulfate, and ammonium dihydrogen phosphate, may include at least one selected from the group consisting of ammonium carbonate, ammonium persulfate, and ammonium dihydrogen phosphate, and may include at least one selected from the group consisting of ammonium carbonate and ammonium persulfate.

The content of the acid component may be in the following range on the basis of the total mass of the polishing liquid from the viewpoint of easily improving the polishing rate for the metallic material. The content of the acid component may be more than 0% by mass, 0.01% by mass or more, 0.02% by mass or more, 0.05% by mass or more, 0.1% by mass or more, 0.2% by mass or more, 0.3% by mass or more, 0.4% by mass or more, 0.5% by mass or more, 0.6% by mass or more, 0.7% by mass or more, 0.8% by mass or more, 0.85% by mass or more, 0.9% by mass or more, 1% by mass or more, 1.1% by mass or more, 1.2% by mass or more, 1.3% by mass or more, 1.4% by mass or more, 1.5% by mass or more, or 1.6% by mass or more. The content of the acid component may be 5% by mass or less, 4.5% by mass or less, 4% by mass or less, 3.5% by mass or less, 3% by mass or less, 2.5% by mass or less, 2% by mass or less, 1.9% by mass or less, 1.8% by mass or less, 1.7% by mass or less, 1.6% by mass or less, 1.5% by mass or less, 1.4% by mass or less, 1.3% by mass or less, 1.2% by mass or less, 1.1% by mass or less, 1% by mass or less, 0.9% by mass or less, 0.85% by mass or less, 0.8% by mass or less, 0.7% by mass or less, 0.6% by mass or less, 0.5% by mass or less, 0.4% by mass or less, 0.3% by mass or less, 0.2% by mass or less, 0.1% by mass or less, 0.05% by mass or less, or 0.02% by mass or less. From these viewpoints, the content of the acid component may be more than 0% by mass and 5% by mass or less, 0.01 to 5% by mass, 0.05 to 5% by mass, more than 0% by mass and 2% by mass or less, 0.01 to 2% by mass, 0.05 to 2% by mass, more than 0% by mass and 1% by mass or less, 0.01 to 1% by mass, 0.05 to 1% by mass, more than 0% by mass and 0.5% by mass or less, 0.01 to 0.5% by mass, or 0.05 to 0.5% by mass.

The content of the organic acid component may be in the following range on the basis of the total mass of the polishing liquid from the viewpoint of easily improving the polishing rate for the metallic material. The content of the organic acid component may be more than 0% by mass, 0.01% by mass or more, 0.02% by mass or more, 0.05% by mass or more, 0.1% by mass or more, 0.15% by mass or more, 0.2% by mass or more, 0.25% by mass or more, 0.3% by mass or more, 0.35% by mass or more, 0.4% by mass or more, 0.41% by mass or more, 0.45% by mass or more, 0.5% by mass or more, 0.6% by mass or more, or 0.8% by mass or more. The content of the organic acid component may be 5% by mass or less, 4% by mass or less, 3% by mass or less, 2% by mass or less, 1% by mass or less, 0.8% by mass or less, 0.6% by mass or less, 0.5% by mass or less, 0.45% by mass or less, 0.41% by mass or less, 0.4% by mass or less, 0.35% by mass or less, 0.3% by mass or less, 0.25% by mass or less, 0.2% by mass or less, 0.15% by mass or less, 0.1% by mass or less, 0.05% by mass or less, or 0.02% by mass or less. From these viewpoints, the content of the organic acid component may be more than 0% by mass and 5% by mass or less, 0.01 to 5% by mass, 0.02 to 5% by mass, 0.1 to 5% by mass, more than 0% by mass and 1% by mass or less, 0.01 to 1% by mass, 0.02 to 1% by mass, 0.1 to 1% by mass, more than 0% by mass and 0.5% by mass or less, 0.01 to 0.5% by mass, 0.02 to 0.5% by mass, or 0.1 to 0.5% by mass.

The content of the inorganic acid component may be in the following range on the basis of the total mass of the polishing liquid from the viewpoint of easily improving the polishing rate for the metallic material. The content of the inorganic acid component may be more than 0% by mass, 0.01% by mass or more, 0.05% by mass or more, 0.1% by mass or more, 0.2% by mass or more, 0.3% by mass or more, 0.4% by mass or more, 0.5% by mass or more, 0.6% by mass or more, 0.7% by mass or more, 0.8% by mass or more, 0.9% by mass or more, 1% by mass or more, 1.1% by mass or more, or 1.2% by mass or more. The content of the inorganic acid component may be 5% by mass or less, 4.5% by mass or less, 4% by mass or less, 3.5% by mass or less, 3% by mass or less, 2.5% by mass or less, 2% by mass or less, 1.8% by mass or less, 1.6% by mass or less, 1.5% by mass or less, 1.4% by mass or less, 1.3% by mass or less, 1.2% by mass or less, 1.1% by mass or less, 1% by mass or less, 0.9% by mass or less, 0.8% by mass or less, or 0.7% by mass or less. From these viewpoints, the content of the inorganic acid component may be more than 0% by mass and 5% by mass or less, 0.01 to 5% by mass, 0.1 to 5% by mass, 0.5 to 5% by mass, more than 0% by mass and 1% by mass or less, 0.01 to 1% by mass, 0.1 to 1% by mass, 0.5 to 1% by mass, more than 0% by mass and 0.9% by mass or less, 0.01 to 0.9% by mass, or 0.1 to 0.9% by mass.

The polishing liquid of the present embodiment may contain an ammonium salt. It is speculated that the ammonium salt or the ammonium cation of the ammonium salt forms a complex with the metallic material so that the polishing rate for the metallic material is easily improved. From the viewpoint of easily improving the polishing rate for the metallic material, the ammonium salt may include an ammonium salt of an inorganic acid and may include an ammonium salt of an organic acid.

The ammonium salt may include at least one selected from the group consisting of an ammonium salt of a monovalent inorganic acid, an ammonium salt of a divalent inorganic acid, and an ammonium salt of a trivalent inorganic acid, from the viewpoint of easily improving the polishing rate for the metallic material. The ammonium salt may include at least one selected from the group consisting of ammonium chloride, ammonium carbonate, ammonium hydrogen carbonate, ammonium sulfate, ammonium persulfate, ammonium dihydrogen phosphate, and ammonium acetate, from the viewpoint of easily improving the polishing rate for the metallic material. From the viewpoint of easily improving the polishing rate for the metallic material, the ammonium salt may include an ammonium salt different from a peroxide and may include a peroxide (such as ammonium persulfate).

The ammonium salt may include a compound having the following molecular weight from the viewpoint of easily improving the polishing rate for the metallic material. The molecular weight may be 50 or more, 60 or more, 70 or more, 75 or more, 78 or more, 80 or more, 90 or more, 100 or more, 110 or more, 120 or more, 130 or more, 140 or more, 150 or more, 180 or more, 200 or more, or 220 or more. The molecular weight may be 1000 or less, less than 1000, 800 or less, 500 or less, 300 or less, 250 or less, 230 or less, 220 or less, 200 or less, 180 or less, 150 or less, 140 or less, 130 or less, 120 or less, 110 or less, 100 or less, 90 or less, 80 or less, or 78 or less. From these viewpoints, the molecular weight may be 50 to 1000, 70 to 1000, 80 to 1000, 50 to 500, 70 to 500, 80 to 500, 50 to 250, 70 to 250, 80 to 250, 50 to 100, 70 to 100, or 80 to 100.

The content of the ammonium salt different from the peroxide may be in the following range on the basis of the total mass of an ammonium salt (the total mass of an ammonium salt contained in the polishing liquid) from the viewpoint of easily improving the polishing rate for the metallic material. The content of the ammonium salt different from the peroxide may be more than 0% by mass, 1% by mass or more, 5% by mass or more, 10% by mass or more, 20% by mass or more, 30% by mass or more, 34% by mass or more, 35% by mass or more, 40% by mass or more, 41% by mass or more, 45% by mass or more, 50% by mass or more, more than 50% by mass, 60% by mass or more, 70% by mass or more, 80% by mass or more, 90% by mass or more, 95% by mass or more, 99% by mass or more, or substantially 100% by mass (an embodiment in which an ammonium salt contained in the polishing liquid is substantially composed of the ammonium salt different from the peroxide). The content of the ammonium salt different from the peroxide may be 100% by mass or less, less than 100% by mass, 99% by mass or less, 95% by mass or less, 90% by mass or less, 80% by mass or less, 70% by mass or less, 60% by mass or less, 50% by mass or less, less than 50% by mass, 45% by mass or less, 41% by mass or less, 40% by mass or less, 35% by mass or less, 34% by mass or less, 30% by mass or less, 20% by mass or less, 10% by mass or less, or 5% by mass or less. From these viewpoints, the content of the ammonium salt different from the peroxide may be more than 0% by mass and 100% by mass or less, 30 to 100% by mass, 50 to 100% by mass, or 80 to 100% by mass.

In a case where the ammonium salt includes a peroxide, the content of the peroxide (ammonium salt) may be in the following range on the basis of the total mass of an ammonium salt (the total mass of an ammonium salt contained in the polishing liquid) from the viewpoint of easily improving the polishing rate for the metallic material. The content of the peroxide (ammonium salt) may be more than 0% by mass, 1% by mass or more, 5% by mass or more, 10% by mass or more, 20% by mass or more, 30% by mass or more, 40% by mass or more, 50% by mass or more, more than 50% by mass, 55% by mass or more, 59% by mass or more, 60% by mass or more, 65% by mass or more, 66% by mass or more, 70% by mass or more, 80% by mass or more, 90% by mass or more, 95% by mass or more, 99% by mass or more, or substantially 100% by mass (an embodiment in which an ammonium salt contained in the polishing liquid is substantially composed of the peroxide). The content of the peroxide (ammonium salt) may be 100% by mass or less, less than 100% by mass, 99% by mass or less, 95% by mass or less, 90% by mass or less, 80% by mass or less, 70% by mass or less, or 66% by mass or less. From these viewpoints, the content of the peroxide (ammonium salt) may be more than 0% by mass and 100% by mass or less, 50 to 100% by mass, 60 to 100% by mass, more than 0% by mass and less than 100% by mass, 50% by mass or more and less than 100% by mass, or 60% by mass or more and less than 100% by mass.

The content of the ammonium salt (the total amount of compounds corresponding to the ammonium salt; the same applies hereinafter) may be in the following range on the basis of the total mass of the polishing liquid from the viewpoint of easily improving the polishing rate for the metallic material. The content of the ammonium salt may be more than 0% by mass, 0.01% by mass or more, 0.02% by mass or more, 0.05% by mass or more, 0.1% by mass or more, 0.2% by mass or more, 0.3% by mass or more, 0.4% by mass or more, 0.45% by mass or more, 0.5% by mass or more, more than 0.5% by mass, 0.6% by mass or more, 0.7% by mass or more, 0.8% by mass or more, 0.85% by mass or more, 0.9% by mass or more, 1% by mass or more, 1.1% by mass or more, or 1.2% by mass or more. The content of the ammonium salt may be 10% by mass or less, 8% by mass or less, 5% by mass or less, 4% by mass or less, 3% by mass or less, 2% by mass or less, 1.8% by mass or less, 1.7% by mass or less, 1.6% by mass or less, 1.5% by mass or less, 1.4% by mass or less, 1.3% by mass or less, 1.2% by mass or less, 1.1% by mass or less, 1% by mass or less, 0.9% by mass or less, 0.85% by mass or less, 0.8% by mass or less, 0.7% by mass or less, 0.6% by mass or less, 0.5% by mass or less, 0.45% by mass or less, 0.4% by mass or less, 0.3% by mass or less, 0.2% by mass or less, 0.1% by mass or less, 0.05% by mass or less, or 0.02% by mass or less. From these viewpoints, the content of the ammonium salt may be more than 0% by mass and 10% by mass or less, more than 0% by mass and 5% by mass or less, more than 0% by mass and 2% by mass or less, more than 0% by mass and 1% by mass or less, 0.01 to 10% by mass, 0.01 to 5% by mass, 0.01 to 2% by mass, 0.01 to 1% by mass, 0.1 to 10% by mass, 0.1 to 5% by mass, 0.1 to 2% by mass, 0.1 to 1% by mass, 0.3 to 10% by mass, 0.3 to 5% by mass, 0.3 to 2% by mass, or 0.3 to 1% by mass.

The content of the ammonium salt different from the peroxide may be in the following range on the basis of the total mass of the polishing liquid from the viewpoint of easily improving the polishing rate for the metallic material. The content of the ammonium salt different from the peroxide may be more than 0% by mass, 0.01% by mass or more, 0.02% by mass or more, 0.05% by mass or more, 0.1% by mass or more, 0.2% by mass or more, 0.3% by mass or more, 0.4% by mass or more, 0.45% by mass or more, 0.5% by mass or more, more than 0.5% by mass, 0.6% by mass or more, 0.7% by mass or more, 0.8% by mass or more, or 0.85% by mass or more. The content of the ammonium salt different from the peroxide may be 10% by mass or less, 8% by mass or less, 5% by mass or less, 4% by mass or less, 3% by mass or less, 2% by mass or less, 1.8% by mass or less, 1.7% by mass or less, 1.6% by mass or less, 1.5% by mass or less, 1.4% by mass or less, 1.3% by mass or less, 1.2% by mass or less, 1.1% by mass or less, 1% by mass or less, 0.9% by mass or less, 0.85% by mass or less, 0.8% by mass or less, 0.7% by mass or less, 0.6% by mass or less, 0.5% by mass or less, 0.45% by mass or less, 0.4% by mass or less, 0.3% by mass or less, 0.2% by mass or less, 0.1% by mass or less, 0.05% by mass or less, or 0.02% by mass or less. From these viewpoints, the content of the ammonium salt different from the peroxide may be more than 0% by mass and 10% by mass or less, more than 0% by mass and 5% by mass or less, more than 0% by mass and 2% by mass or less, more than 0% by mass and 1% by mass or less, 0.01 to 10% by mass, 0.01 to 5% by mass, 0.01 to 2% by mass, 0.01 to 1% by mass, 0.1 to 10% by mass, 0.1 to 5% by mass, 0.1 to 2% by mass, 0.1 to 1% by mass, 0.3 to 10% by mass, 0.3 to 5% by mass, 0.3 to 2% by mass, or 0.3 to 1% by mass.

In a case where the ammonium salt includes a peroxide, the content of the peroxide (ammonium salt) may be in the following range on the basis of the total mass of the polishing liquid from the viewpoint of easily improving the polishing rate for the metallic material. The content of the peroxide (ammonium salt) may be more than 0% by mass, 0.01% by mass or more, 0.05% by mass or more, 0.1% by mass or more, 0.2% by mass or more, 0.3% by mass or more, 0.4% by mass or more, 0.5% by mass or more, more than 0.5% by mass, 0.6% by mass or more, 0.65% by mass or more, 0.7% by mass or more, 0.75% by mass or more, or 0.8% by mass or more. The content of the peroxide (ammonium salt) may be 5% by mass or less, 4% by mass or less, 3% by mass or less, 2% by mass or less, 1.5% by mass or less, 1.2% by mass or less, 1% by mass or less, 0.9% by mass or less, or 0.8% by mass or less. From these viewpoints, the content of the peroxide (ammonium salt) may be more than 0% by mass and 5% by mass or less, 0.01 to 5% by mass, 0.1 to 5% by mass, 0.5 to 5% by mass, more than 0% by mass and 1% by mass or less, 0.01 to 1% by mass, 0.1 to 1% by mass, or 0.5 to 1% by mass.

The content of the ammonium salt may be in the following range with respect to 100 parts by mass of the abrasive grains from the viewpoint of easily improving the polishing rate for the metallic material. The content of the ammonium salt may be more than 0 parts by mass, 1 part by mass or more, 2 parts by mass or more, 5 parts by mass or more, 10 parts by mass or more, 20 parts by mass or more, 30 parts by mass or more, 40 parts by mass or more, 45 parts by mass or more, 50 parts by mass or more, 60 parts by mass or more, 70 parts by mass or more, 80 parts by mass or more, 85 parts by mass or more, 90 parts by mass or more, 100 parts by mass or more, 110 parts by mass or more, or 120 parts by mass or more. The content of the ammonium salt may be 1000 parts by mass or less, 800 parts by mass or less, 500 parts by mass or less, 400 parts by mass or less, 300 parts by mass or less, 200 parts by mass or less, 180 parts by mass or less, 170 parts by mass or less, 160 parts by mass or less, 150 parts by mass or less, 140 parts by mass or less, 130 parts by mass or less, 120 parts by mass or less, 110 parts by mass or less, 100 parts by mass or less, 90 parts by mass or less, 85 parts by mass or less, 80 parts by mass or less, 70 parts by mass or less, 60 parts by mass or less, 50 parts by mass or less, 45 parts by mass or less, 40 parts by mass or less, 30 parts by mass or less, 20 parts by mass or less, 10 parts by mass or less, 5 parts by mass or less, or 2 parts by mass or less. From these viewpoints, the content of the ammonium salt may be more than 0 parts by mass and 1000 parts by mass or less, more than 0 parts by mass and 500 parts by mass or less, more than 0 parts by mass and 200 parts by mass or less, more than 0 parts by mass and 100 parts by mass or less, 1 to 1000 parts by mass, 1 to 500 parts by mass, 1 to 200 parts by mass, 1 to 100 parts by mass, 10 to 1000 parts by mass, 10 to 500 parts by mass, 10 to 200 parts by mass, 10 to 100 parts by mass, 30 to 1000 parts by mass, 30 to 500 parts by mass, 30 to 200 parts by mass, or 30 to 100 parts by mass.

The content of the ammonium salt different from the peroxide may be in the following range with respect to 100 parts by mass of the abrasive grains from the viewpoint of easily improving the polishing rate for the metallic material. The content of the ammonium salt different from the peroxide may be more than 0 parts by mass, 1 part by mass or more, 2 parts by mass or more, 5 parts by mass or more, 10 parts by mass or more, 20 parts by mass or more, 30 parts by mass or more, 40 parts by mass or more, 45 parts by mass or more, 50 parts by mass or more, 60 parts by mass or more, 70 parts by mass or more, 80 parts by mass or more, or 85 parts by mass or more. The content of the ammonium salt different from the peroxide may be 1000 parts by mass or less, 800 parts by mass or less, 500 parts by mass or less, 400 parts by mass or less, 300 parts by mass or less, 200 parts by mass or less, 180 parts by mass or less, 170 parts by mass or less, 160 parts by mass or less, 150 parts by mass or less, 140 parts by mass or less, 130 parts by mass or less, 120 parts by mass or less, 110 parts by mass or less, 100 parts by mass or less, 90 parts by mass or less, 85 parts by mass or less, 80 parts by mass or less, 70 parts by mass or less, 60 parts by mass or less, 50 parts by mass or less, 45 parts by mass or less, 40 parts by mass or less, 30 parts by mass or less, 20 parts by mass or less, 10 parts by mass or less, 5 parts by mass or less, or 2 parts by mass or less. From these viewpoints, the content of the ammonium salt different from the peroxide may be more than 0 parts by mass and 1000 parts by mass or less, more than 0 parts by mass and 500 parts by mass or less, more than 0 parts by mass and 200 parts by mass or less, more than 0 parts by mass and 100 parts by mass or less, 1 to 1000 parts by mass, 1 to 500 parts by mass, 1 to 200 parts by mass, 1 to 100 parts by mass, 10 to 1000 parts by mass, 10 to 500 parts by mass, 10 to 200 parts by mass, 10 to 100 parts by mass, 30 to 1000 parts by mass, 30 to 500 parts by mass, 30 to 200 parts by mass, or 30 to 100 parts by mass.

In a case where the ammonium salt includes a peroxide, the content of the peroxide (ammonium salt) may be in the following range with respect to 100 parts by mass of the abrasive grains from the viewpoint of easily improving the polishing rate for the metallic material. The content of the peroxide (ammonium salt) may be more than 0 parts by mass, 1 part by mass or more, 5 parts by mass or more, 10 parts by mass or more, 20 parts by mass or more, 30 parts by mass or more, 40 parts by mass or more, 50 parts by mass or more, 60 parts by mass or more, 65 parts by mass or more, 70 parts by mass or more, 75 parts by mass or more, or 80 parts by mass or more. The content of the peroxide (ammonium salt) may be 500 parts by mass or less, 400 parts by mass or less, 300 parts by mass or less, 200 parts by mass or less, 150 parts by mass or less, 120 parts by mass or less, 100 parts by mass or less, 90 parts by mass or less, 80 parts by mass or less, 75 parts by mass or less, 70 parts by mass or less, 65 parts by mass or less, 60 parts by mass or less, 50 parts by mass or less, or 40 parts by mass or less. From these viewpoints, the content of the peroxide (ammonium salt) may be more than 0 parts by mass and 500 parts by mass or less, 1 to 500 parts by mass, 10 to 500 parts by mass, 50 to 500 parts by mass, more than 0 parts by mass and 100 parts by mass or less, 1 to 100 parts by mass, 10 to 100 parts by mass, or 50 to 100 parts by mass.

The polishing liquid of the present embodiment may contain ammonia. It is speculated that the ammonia forms a complex with the metallic material so that the polishing rate for the metallic material is easily improved. From the viewpoint of easily improving the polishing rate for the metallic material, the polishing liquid of the present embodiment may contain at least one selected from the group consisting of an ammonium cation and ammonia and may contain at least one selected from the group consisting of an ammonium salt (such as the aforementioned ammonium salt of the inorganic acid and the aforementioned ammonium salt of the organic acid) and ammonia.

The content of the ammonia may be in the following range on the basis of the total mass of the polishing liquid from the viewpoint of easily improving the polishing rate for the metallic material. The content of the ammonia may be more than 0% by mass, 0.01% by mass or more, 0.03% by mass or more, 0.05% by mass or more, 0.08% by mass or more, 0.1% by mass or more, 0.12% by mass or more, 0.15% by mass or more, 0.2% by mass or more, 0.25% by mass or more, or 0.3% by mass or more. The content of the ammonia may be 5% by mass or less, 4% by mass or less, 3% by mass or less, 2% by mass or less, 1.5% by mass or less, 1% by mass or less, 0.8% by mass or less, 0.6% by mass or less, 0.5% by mass or less, 0.4% by mass or less, 0.3% by mass or less, 0.25% by mass or less, 0.2% by mass or less, 0.15% by mass or less, or 0.1% by mass or less. From these viewpoints, the content of the ammonia may be more than 0% by mass and 5% by mass or less, 0.01 to 5% by mass, 0.1 to 5% by mass, 0.2 to 5% by mass, more than 0% by mass and 2% by mass or less, 0.01 to 2% by mass, 0.1 to 2% by mass, 0.2 to 2% by mass, more than 0% by mass and 0.5% by mass or less, 0.01 to 0.5% by mass, 0.1 to 0.5% by mass, or 0.2 to 0.5% by mass.

The content of the ammonia may be in the following range with respect to 100 parts by mass of the abrasive grains from the viewpoint of easily improving the polishing rate for the metallic material. The content of the ammonia may be more than 0 parts by mass, 1 part by mass or more, 3 parts by mass or more, 5 parts by mass or more, 8 parts by mass or more, 10 parts by mass or more, 12 parts by mass or more, 15 parts by mass or more, 20 parts by mass or more, 25 parts by mass or more, or 30 parts by mass or more. The content of the ammonia may be 500 parts by mass or less, 400 parts by mass or less, 300 parts by mass or less, 200 parts by mass or less, 150 parts by mass or less, 100 parts by mass or less, 80 parts by mass or less, 60 parts by mass or less, 50 parts by mass or less, less than 50 parts by mass, 40 parts by mass or less, 30 parts by mass or less, 25 parts by mass or less, 20 parts by mass or less, 15 parts by mass or less, 10 parts by mass or less, 8 parts by mass or less, or 5 parts by mass or less. From these viewpoints, the content of the ammonia may be more than 0 parts by mass and 500 parts by mass or less, 1 to 500 parts by mass, 10 to 500 parts by mass, 20 to 500 parts by mass, more than 0 parts by mass and 200 parts by mass or less, 1 to 200 parts by mass, 10 to 200 parts by mass, 20 to 200 parts by mass, more than 0 parts by mass and 50 parts by mass or less, 1 to 50 parts by mass, 10 to 50 parts by mass, or 20 to 50 parts by mass.

The content of the ammonia may be in the following range with respect to 100 parts by mass of the ammonium salt from the viewpoint of easily improving the polishing rate for the metallic material. The content of the ammonia may be more than 0 parts by mass, 1 part by mass or more, 5 parts by mass or more, 10 parts by mass or more, 15 parts by mass or more, 20 parts by mass or more, 25 parts by mass or more, 30 parts by mass or more, 35 parts by mass or more, 36 parts by mass or more, 40 parts by mass or more, 50 parts by mass or more, 60 parts by mass or more, 80 parts by mass or more, 100 parts by mass or more, 150 parts by mass or more, 200 parts by mass or more, 300 parts by mass or more, 500 parts by mass or more, 1000 parts by mass or more, or 1500 parts by mass or more. The content of the ammonia may be 2000 parts by mass or less, 1500 parts by mass or less, 1000 parts by mass or less, 500 parts by mass or less, 300 parts by mass or less, 200 parts by mass or less, 150 parts by mass or less, 100 parts by mass or less, 80 parts by mass or less, 60 parts by mass or less, 50 parts by mass or less, 40 parts by mass or less, 36 parts by mass or less, 35 parts by mass or less, 30 parts by mass or less, 25 parts by mass or less, 20 parts by mass or less, or 15 parts by mass or less. From these viewpoints, the content of the ammonia may be more than 0 parts by mass and 2000 parts by mass or less, 10 to 2000 parts by mass, 100 to 2000 parts by mass, 300 to 2000 parts by mass, more than 0 parts by mass and 1500 parts by mass or less, 10 to 1500 parts by mass, 100 to 1500 parts by mass, 300 to 1500 parts by mass, or 1 to 200 parts by mass.

The polishing liquid of the present embodiment may contain an anticorrosive agent (an anticorrosive agent for the metallic material) as a compound having an anticorrosive action with respect to the metallic material. The anticorrosive agent forms a protective film with respect to the metallic material to suppress the etching of the metallic material, so that roughness of the polished surface is likely to be reduced.

The anticorrosive agent may include at least one selected from the group consisting of a triazole compound, a pyridine compound, a pyrazole compound, a pyrimidine compound, an imidazole compound, a guanidine compound, a thiazole compound, a tetrazole compound, a triazine compound, and hexamethylenetetramine. The term "compound" is a collective term for compounds having a skeleton thereof, and for example, the "triazole compound" means a compound having a triazole skeleton. From the viewpoint of easily obtaining a suitable anticorrosive action, the anticorrosive agent may include at least one selected from the group consisting of a triazole compound, a pyridine compound, an imidazole compound, a tetrazole compound, a triazine compound, and hexamethylenetetramine, may include a triazole compound, and may include a benzotriazole compound.

Examples of the triazole compound include 1,2,3-triazole, 1,2,4-triazole, 3-amino-1H-1,2,4-triazole, benzotriazole, 1-hydroxybenzotriazole, 1-dihydroxypropylbenzotriazole, 2,3-dicarboxypropylbenzotriazole, 4-hydroxybenzotriazole, 4-carboxy-1H-benzotriazole, 4-carboxy-1H-benzotriazole methyl ester (methyl 1H-benzotriazole-4-carboxylate), 4-carboxy-1H-benzotriazole butyl ester (butyl 1H-benzotriazole-4-carboxylate), 4-carboxy-1H-benzotriazole octyl ester (octyl 1H-benzotriazole-4-carboxylate), 5-hexylbenzotriazole, [1,2,3-benzotriazolyl-1-methyl] [1,2,4-triazolyl-1-methyl] [2-ethylhexyl]amine, tolyltriazole, naphthotriazole, bis[(1-benzotriazolyl)methyl]phosphonic acid, 3H-1,2,3-triazolo[4,5-b]pyridin-3-ol, 1H-1,2,3-triazolo[4,5-b]pyridin, 1-acetyl-1H-1,2,3-triazolo[4,5-b]pyridin, 1,2,4-triazolo[1,5-a]pyrimidine, 2-methyl-5,7-diphenyl-[1,2,4]triazolo[1,5-a]pyrimidine, 2-methylsulfanyl-5,7-diphenyl-[1,2,4]triazolo[1,5-a]pyrimidine, and 2-methylsulfanyl-5,7-diphenyl-4,7-dihydro-[1,2,4]triazolo[1,5-a]pyrimidine. The compounds having a triazole skeleton and another skeleton in one molecule shall be classified into the triazole compound. From the viewpoint of easily obtaining a suitable anticorrosive action, the polishing liquid of the present embodiment may contain a triazole compound having a hydroxy group and may contain 1-hydroxybenzotriazole.

As the content of the anticorrosive agent, the content of the triazole compound, or the content of the benzotriazole compound, a content D may be in the following range on the basis of the total mass of the polishing liquid from the viewpoint of easily obtaining a suitable anticorrosive action. The content D may be more than 0% by mass, 0.001% by mass or more, 0.003% by mass or more, 0.005% by mass or more, 0.008% by mass or more, 0.01% by mass or more, 0.02% by mass or more, 0.025% by mass or more, 0.03% by mass or more, 0.04% by mass or more, 0.05% by mass or more, 0.08% by mass or more, 0.1% by mass or more, 0.3% by mass or more, 0.5% by mass or more, or 1% by mass or more. The content D may be 2% by mass or less, 1.5% by mass or less, 1% by mass or less, 0.5% by mass or less, 0.3% by mass or less, 0.1% by mass or less, 0.08% by mass or less, 0.05% by mass or less, 0.04% by mass or less, 0.03% by mass or less, 0.025% by mass or less, 0.02% by mass or less, 0.01% by mass or less, or 0.008% by mass or less. From these viewpoints, the content D may be more than 0% by mass and 2% by mass or less, 0.001 to 2% by mass, 0.005 to 2% by mass, 0.01 to 2% by mass, more than 0% by mass and 1% by mass or less, 0.001 to 1% by mass, 0.005 to 1% by mass, 0.01 to 1% by mass, more than 0% by mass and 0.1% by mass or less, 0.001 to 0.1% by mass, 0.005 to 0.1% by mass, or 0.01 to 0.1% by mass.

The polishing liquid of the present embodiment may contain a basic hydroxide. By using a basic hydroxide, the polishing rate for the metallic material is easily improved. Examples of the basic hydroxide include alkali metal hydroxides such as sodium hydroxide and potassium hydroxide; alkaline earth metal hydroxides; and tetramethylammonium hydroxide (TMAH).

The content of the basic hydroxide may be in the following range on the basis of the total mass of the polishing liquid from the viewpoint of easily improving the polishing rate for the metallic material. The content of the basic hydroxide may be more than 0% by mass, 0.01% by mass or more, 0.05% by mass or more, 0.1% by mass or more, 0.15% by mass or more, 0.2% by mass or more, 0.25% by mass or more, 0.3% by mass or more, 0.35% by mass or more, 0.36% by mass or more, 0.4% by mass or more, 0.45% by mass or more, or 0.48% by mass or more. The content of the basic hydroxide may be 5% by mass or less, 4% by mass or less, 3% by mass or less, 2% by mass or less, 1% by mass or less, 0.8% by mass or less, 0.6% by mass or less, 0.5% by mass or less, 0.48% by mass or less, 0.45% by mass or less, 0.4% by mass or less, or 0.36% by mass or less. From these viewpoints, the content of the basic hydroxide may be more than 0% by mass and 5% by mass or less, 0.01 to 5% by mass, 0.1 to 5% by mass, more than 0% by mass and 1% by mass or less, 0.01 to 1% by mass, or 0.1 to 1% by mass.

The polishing liquid of the present embodiment may contain a peroxide not corresponding to the aforementioned ammonium salt, and may not contain this peroxide. Examples of the peroxide include potassium persulfate, hydrogen peroxide, ferric nitrate, sulfate iron, ozone, hypochlorous acid, hypochlorite, potassium periodate, and peracetic acid. The polishing liquid of the present embodiment may not contain hydrogen peroxide. The content of the peroxide or the content of the hydrogen peroxide may be 0.1% by mass or less, less than 0.1% by mass, 0.01% by mass or less, 0.001% by mass or less, or substantially 0% by mass on the basis of the total mass of the polishing liquid.

The polishing liquid of the present embodiment may not contain dihydroxyethylglycine, aminopolycarboxylic acid, and a non-metallic salt of aminopolycarboxylic acid. The content (total amount) of the dihydroxyethylglycine, the aminopolycarboxylic acid, and the non-metallic salt of aminopolycarboxylic acid may be 0.05% by mass or less, less than 0.05% by mass, 0.01% by mass or less, 0.001% by mass or less, or substantially 0% by mass on the basis of the total mass of the polishing liquid.

The polishing liquid of the present embodiment may not contain a compound having a monomer unit of unsaturated carboxylic acid, and may not contain a polycarboxylic acid-based polymer dispersant. The content of the compound having a monomer unit of unsaturated carboxylic acid or the content of the polycarboxylic acid-based polymer dispersant may be 0.0005% by mass or less, less than 0.0005% by mass, 0.0001% by mass or less, 0.00001% by mass or less, or substantially 0% by mass on the basis of the total mass of the polishing liquid.

### (pH)

The pH of the polishing liquid of the present embodiment may be in the following range from the viewpoint of easily improving the polishing rate for the member to be polished containing a resin and the polishing rate for the metallic material. The pH of the polishing liquid may be 3.00 or more, 4.00 or more, more than 4.00, 5.00 or more, more than 5.00, 6.00 or more, 7.00 or more, more than 7.00, 7.50 or more, 8.00 or more, more than 8.00, 8.50 or more, 9.00 or more, 9.30 or more, 9.40 or more, 9.50 or more, 9.60 or more, 9.80 or more, 10.00 or more, more than 10.00, 10.20 or more, 10.30 or more, 10.50 or more, or 10.80 or more. The pH of the polishing liquid may be 13.00 or less, 12.00 or less, 11.80 or less, 11.50 or less, 11.00 or less, 10.80 or less, 10.50 or less, 10.30 or less, 10.20 or less, 10.00 or less, less than 10.00, 9.80 or less, 9.60 or less, 9.50 or less, 9.40 or less, 9.30 or less, 9.00 or less, 8.50 or less, or 8.00 or less. From these viewpoints, the pH of the polishing liquid may be 3.00 to 13.00, 7.00 to 13.00, 8.00 to 13.00, 9.00 to 13.00, 3.00 to 12.00, 7.00 to 12.00, 8.00 to 12.00, 9.00 to 12.00, 3.00 to 11.00, 7.00 to 11.00, 8.00 to 11.00, or 9.00 to 11.00. The pH of the polishing liquid can be adjusted by the aforementioned acid component, ammonia, basic hydroxide, and the like.

The pH of the polishing liquid of the present embodiment can be measured with a pH meter (for example, Product No. PHL-40 manufactured by DKK-TOA CORPORATION). For example, the pH meter is subjected to two-point calibration by using a phthalate pH buffer solution (pH: 4.01) and a neutral phosphate pH buffer solution (pH: 6.86) as standard buffer solutions, subsequently the electrode of the pH meter is introduced into the polishing liquid, and the value after being stabilized after a lapse of two minutes or longer is measured. At this time, both the liquid temperatures of the standard buffer solutions and the polishing liquid are set to 25°C.

### (Storage mode)

The polishing liquid of the present embodiment may be stored as a stock solution for a polishing liquid in such a state that the amount of water is more reduced than that during use. The stock solution for a polishing liquid is a stock solution for obtaining the polishing liquid, and the stock solution for a polishing liquid is diluted with water before use or during use to obtain the polishing liquid. The dilution ratio is, for example, 1.5 times or more.

The polishing liquid of the present embodiment may be stored as a one-pack polishing liquid containing at least abrasive grains and an ether compound A, and may be stored as a multi-pack polishing liquid having a slurry (first liquid) and an additive liquid (second liquid). In the multi-pack polishing liquid, the constituent components of the polishing liquid are divided into the slurry and the additive liquid so that the slurry and the additive liquid are mixed to form the polishing liquid. The slurry contains, for example, at least abrasive grains and water. The additive liquid contains, for example, at least an ether compound A and water. The component other than the abrasive grains, the ether compound A, and water may be contained in the additive liquid of the slurry and the additive liquid. The constituent components of the polishing liquid may be stored separately in three or more liquids. In the multi-pack polishing liquid, the polishing liquid may be prepared by mixing the slurry and the additive liquid immediately before polishing or during polishing. The polishing liquid may be prepared by supplying each of the slurry and the additive liquid of the multi-pack polishing liquid onto a polishing platen to mix the slurry and the additive liquid on the polishing platen.

### <Polishing method>

A polishing method of the present embodiment includes a polishing step of polishing a member to be polished containing a resin by using the polishing liquid of the present embodiment. In the polishing step, a surface to be polished of the member to be polished can be polished, and the surface to be polished in which the resin is present can be polished. In the polishing step, at least a part of the resin in the member to be polished can be removed by polishing. The polishing liquid used in the polishing step may be the aforementioned one-pack polishing liquid, may be a polishing liquid obtained by diluting the aforementioned stock solution for a polishing liquid with water, and may be a polishing liquid obtained by mixing a slurry and an additive liquid of the aforementioned multi-pack polishing liquid. The member to be polished is not particularly limited, but may be a wafer (for example, a semiconductor wafer), and may be a chip (for example, a semiconductor chip). The member to be polished may be a wiring board and may be a circuit board.

The member to be polished may contain a resin and a silicon compound (for example, silicon oxide) and may contain a resin and particles containing a silicon compound. In the polishing step, a surface to be polished in which the resin and the silicon compound are present can be polished. The member to be polished may contain a resin and a metallic material (for example, copper-based metal). In the polishing step, a surface to be polished in which the resin and the metallic material are present can be polished. The member to be polished may contain a resin, a silicon compound (for example, silicon oxide), and a metallic material (for example, copper-based metal) and may contain a resin, particles containing a silicon compound, and a metallic material. In the polishing step, a surface to be polished in which the resin, the silicon compound, and the metallic material are present can be polished. Examples of metals of the metallic material include copper, cobalt, tantalum, aluminum, titanium, tungsten, and manganese. Examples of the silicon compound include silicon oxide (for example, SiO₂), SiOC, and silicon nitride (for example, SiN). In the polishing step, the resin may include an epoxy resin, and the member to be polished may contain a resin and particles containing a silicon oxide. The shape of the member to be polished is not particularly limited, and may have, for example, a film shape as a configuration other than the aforementioned configuration. The member to be polished may have an object to be polished (at least one selected from the group consisting of a resin, a silicon compound, and a metallic material) on a substrate having concave portions and convex portions on the surface thereof. The member to be polished may contain another material to be polished (for example, an insulating material) in addition to at least one selected from the group consisting of a resin, a silicon compound, and a metallic material.

### <Manufacturing method and the like>

A method for producing a component of the present embodiment includes a component producing step of obtaining a component by using a polished member (base substrate) polished by the polishing method of the present embodiment. A component of the present embodiment is a component obtained by the method of producing a component of the present embodiment. The component of the present embodiment is not particularly limited, and may be an electronic component (for example, a semiconductor component such as a semiconductor package), may be a wafer (for example, a semiconductor wafer), and may be a chip (for example, a semiconductor chip). As an embodiment of the method for producing a component of the present embodiment, in a method for producing an electronic component of the present embodiment, an electronic component is obtained by using a polished member polished by the polishing method of the present embodiment. As an embodiment of the method for producing a component of the present embodiment, in a method for producing a semiconductor component of the present embodiment, a semiconductor component (for example, a semiconductor package) is obtained by using a polished member polished by the polishing method of the present embodiment. The method for producing a component of the present embodiment may include a polishing step of polishing a member to be polished by the polishing method of the present embodiment before the component producing step.

The method for producing a component of the present embodiment may include, as an embodiment of the component producing step, an individually dividing step of dividing a polished member (base substrate) polished by the polishing method of the present embodiment into individual pieces. The individually dividing step may be, for example, a step of dicing a wafer (for example, a semiconductor wafer) polished by the polishing method of the present embodiment to obtain chips (for example, semiconductor chips). As an embodiment of the method for producing a component of the present embodiment, the method for producing an electronic component of the present embodiment may include a step of obtaining an electronic component (for example, a semiconductor component) by individually dividing a polished member polished by the polishing method of the present embodiment into individual pieces. As an embodiment of the method for producing a component of the present embodiment, the method for producing a semiconductor component of the present embodiment may include a step of obtaining a semiconductor component (for example, a semiconductor package) by individually dividing a polished member polished by the polishing method of the present embodiment into individual pieces.

The method for producing a component of the present embodiment may include, as an embodiment of the component producing step, a connecting step of connecting (for example, electrically connecting) a polished member (base substrate) polished by the polishing method of the present embodiment to another body to be connected. The body to be connected that is connected to the polished member polished by the polishing method of the present embodiment is not particularly limited, and may be a polished member polished by the polishing method of the present embodiment, and may be a body to be connected different from the polished member polished by the polishing method of the present embodiment. In the connecting step, the polished member and the body to be connected may be directly connected to each other (connected in a state where the polished member and the body to be connected are in contact with each other), and the polished member and the body to be connected may be connected via another member (such as a conductive member). The connecting step can be performed before the individually dividing step, after the individually dividing step, or before and after the individually dividing step.

The connecting step may be a step of connecting a polished surface of a polished member polished by the polishing method of the present embodiment to a body to be connected, and may be a step of connecting a connection surface of a polished member polished by the polishing method of the present embodiment to a connection surface of a body to be connected. The connection surface of the polished member may be a polished surface polished by the polishing method of the present embodiment. A connection body having the polished member and the body to be connected can be obtained by the connecting step. In the connecting step, in a case where the connection surface of the polished member has a metal portion, the body to be connected may be connected to the metal portion. In the connecting step, in a case where the connection surface of the polished member has a metal portion and the connection surface of the body to be connected has a metal portion, the metal portions may be connected to each other. The metal portion may contain copper.

A device of the present embodiment (for example, an electronic device such as a semiconductor device) has at least one selected from the group consisting of the polished member polished by the polishing method of the present embodiment and the component of the present embodiment.

### Examples

Hereinafter, the present disclosure will be specifically described on the basis of Examples; however, the present disclosure is not limited to these Examples.

### <Preparation of polishing liquid>

By mixing each component in Table 1 and distilled water, a polishing liquid having the composition shown in Table 1 was obtained. Table 1 shows the content (unit: % by mass) of each component based on the total mass of the polishing liquid, with the residue being distilled water. As cerium oxide particles, trade name "HS-8005" manufactured by Showa Denko Materials Co., Ltd. was used. "MMB" means 3-methoxy-3-methyl-1-butanol, "HBTA" means 1-hydroxybenzotriazole, and "BTA" means benzotriazole. As the polyglycerol, trade name "PGL750" (glycerol decamer, weight average molecular weight: 750, hydroxyl value: 870 to 910) manufactured by Sakamoto Yakuhin Kogyo Co., Ltd. was used. MMB, polyglycerol, and 1-propoxy-2-propanol correspond to the ether compound A.

### <Average particle diameter of abrasive grains>

The average particle diameter of the abrasive grains in the polishing liquid in each Example was determined by using "Microtrac MT3300EXII" manufactured by MicrotracBEL Corp. In each Example, the average particle diameter D50 was 341 nm, and the average particle diameter D80 was 609 nm.

### <pH of polishing liquid>

The pH of the polishing liquid was measured by using a pH meter (Model No.: PHL-40 manufactured by DKK-TOA CORPORATION). The pH meter was subjected to two-point calibration by using a phthalate pH buffer solution (pH: 4.01) and a neutral phosphate pH buffer solution (pH: 6.86) as standard buffer solutions, subsequently the electrode of the pH meter was introduced into the polishing liquid, and the value after being stabilized after a lapse of two minutes or longer was measured. The results are shown in Table 1.

### <Polishing evaluation>

As a base substrate A for evaluating the polishing rate for the member to be polished containing a resin, a base substrate having a base material portion containing an epoxy resin and particles containing silicon oxide, and a metal portion disposed in an opening formed in the base material portion (an opening extending in a thickness direction of the base substrate (the thickness direction of the base material portion)) and containing copper (a base substrate having a metal portion extending in a thickness direction of the base substrate (the thickness direction of the base material portion) and containing copper and a base material portion covering the outer periphery of the metal portion (a base material portion containing an epoxy resin and particles containing silicon oxide)) was prepared. A plurality of metal portions having a diameter of 200 µm or less were arranged in an array. The cross-sectional shape of the metal portion perpendicular to the thickness direction of the base substrate was circular. The base substrate A had a surface to be polished in which an epoxy resin, particles containing silicon oxide, and copper are present.

As a base substrate B for evaluating the polishing rate of copper in Examples 2, 3, and 9 to 11, a base substrate having a copper film formed on a φ300 mm silicon wafer was prepared.

In a polishing apparatus (manufactured by Applied Materials, Inc., trade name: Reflexion LK), the base substrate (the base substrate A or the base substrate B) was attached to a holder for attaching a base substrate to which an adsorption pad was attached. The holder was placed on a platen to which a pad made of a porous urethane resin was attached such that the surface to be polished (for the base substrate A, an area where the aforementioned metal portion was disposed) faced the pad. The base substrate was pressed against the pad at a polishing load of 4 psi while supplying the aforementioned polishing liquid onto the pad at an amount supplied of 350 mL/min. At this time, polishing was performed by rotating the platen at 147 min⁻¹ and the holder at 153 min⁻¹. The polishing time for the base substrate A was 5 minutes, and the polishing time for the base substrate B was 1 minute. The base substrate after polishing was thoroughly washed with pure water and then dried.

The amount of change in the thickness of the base substrate A before and after polishing was measured using a stylus profiler, and the polishing rate for the member to be polished containing a resin was determined. An average value of the amounts of change in the thickness was measured at a total of five areas in the center portion of the base substrate and four areas of the outer periphery of the base substrate (four areas positioned around the center portion of the base substrate with an equal interval). The results are shown in Table 1.

The amount of change in the thickness of the copper film before and after polishing in the base substrate B was measured using a metal film thickness measuring instrument (manufactured by Hitachi Kokusai Electric Inc., trade name: VR-120/08S), and the polishing rate for copper was determined. The thicknesses at 65 points positioned on the line (diameter) passing through the center of the base substrate B with an equal interval were measured, and an average value thereof was obtained as the thickness of the copper film. The results are shown in Table 1.

**[Table 1]**

| | | Example | | | | | | | | | | | Comparative Example |
|---|---|---|---|---|---|---|---|---|---|---|---|---|---|
| | | 1 | 2 | 3 | 4 | 5 | 6 | 7 | 8 | 9 | 10 | 11 | 1 |
| Composition | Cerium oxide particles | 1 | 1 | 1 | 1 | 1 | 2 | 1 | 1 | 1 | 1 | 1 | 1 |
| | Ammonium carbonate | 0.85 | 0.85 | 0.42 | | | | | | | | | |
| | Ammonium persulfate | | | 0.80 | 0.80 | 0.80 | 0.80 | 0.80 | 0.80 | 0.80 | | | 0.80 |
| | Ammonium acetate | | | | | | | | | 0.02 | 0.02 | | |
| | Ammonium hydrogen carbonate | | | | | | | | | | | 0.70 | |
| | Ammonia | | | | 0.10 | 0.10 | 0.10 | 0.10 | 0.15 | 0.30 | 0.30 | | 0.15 |
| | MMB | 0.333 | 0.333 | 0.305 | 0.100 | 0.100 | 0.100 | 0.100 | | 0.333 | 0.333 | 0.333 | |
| | Polyglycerol | 1 | 1 | 1 | | | | | 1 | 1 | 1 | 1 | |
| | 1-Propoxy-2-propanol | | | | | | | | 0.666 | | | | |
| | Malic acid | | | 0.01 | 0.01 | 0.01 | 0.01 | 0.01 | 0.01 | | | | 0.01 |
| | Glycine | | | 0.4 | 0.8 | 0.8 | 0.8 | 0.8 | 0.4 | | | | 0.4 |
| | HBTA | 0.010 | 0.010 | 0.025 | | | | | 0.030 | 0.008 | 0.008 | 0.008 | 0.030 |
| | BTA | | | | | 0.1 | 0.1 | 1.0 | | | | | |
| | Potassium hydroxide | | 0.48 | 0.48 | 0.36 | 0.36 | 0.36 | 0.36 | 0.48 | | | | 0.48 |
| pH | | 8.90 | 9.70 | 9.33 | 9.56 | 9.52 | 9.48 | 9.07 | 9.53 | 10.67 | 10.89 | 7.99 | 9.97 |
| Polishing rate [µm/min] | Resin-containing member | 0.43 | 0.49 | 0.55 | 0.49 | 0.50 | 0.70 | 0.48 | 0.52 | 0.60 | 0.44 | 0.43 | 0.40 |
| | Copper | - | 0.68 | 1.32 | - | - | - | - | - | 1.21 | 0.40 | 0.31 | - |

### Reference Signs List

10: member to be polished, 12: base material portion, 12a: resin, 12b: particle, 14: metal portion.

## Claims

1. A polishing liquid for polishing a member to be polished containing a resin, the polishing liquid comprising abrasive grains containing cerium oxide and an ether compound having a hydroxy group.

2. The polishing liquid according to claim 1, wherein the ether compound includes an alkoxy alcohol.

3. The polishing liquid according to claim 2, wherein the ether compound includes an alkoxy alcohol having a molecular weight of less than 200.

4. The polishing liquid according to claim 2, wherein the alkoxy alcohol includes a compound having an alkoxy group having 1 to 5 carbon atoms.

5. The polishing liquid according to claim 2, wherein the alkoxy alcohol includes 1-propoxy-2-propanol.

6. The polishing liquid according to claim 2, wherein the alkoxy alcohol includes 3-methoxy-3-methyl-1-butanol.

7. The polishing liquid according to claim 2, wherein a content of the alkoxy alcohol is 0.2 to 0.8% by mass on the basis of the total mass of the polishing liquid.

8. The polishing liquid according to claim 2, wherein the ether compound further includes a polyether.

9. The polishing liquid according to claim 8, wherein the polyether includes polyglycerol.

10. The polishing liquid according to claim 8, wherein a content of the polyether is 0.5 to 3% by mass on the basis of the total mass of the polishing liquid.

11. The polishing liquid according to claim 1, wherein a content of the abrasive grains is 0.5 to 2% by mass on the basis of the total mass of the polishing liquid.

12. The polishing liquid according to claim 1, further comprising an organic acid component.

13. The polishing liquid according to claim 1, further comprising at least one selected from the group consisting of an ammonium cation and ammonia.

14. The polishing liquid according to claim 1, wherein a pH is 9.00 to 11.00.

15. A polishing method, comprising: polishing a member to be polished containing a resin by using the polishing liquid according to any one of claims 1 to 14.

16. The polishing method according to claim 15, wherein the resin includes an epoxy resin.

17. The polishing method according to claim 15, wherein the member to be polished further contains particles containing silicon oxide.

18. A method for manufacturing a component, comprising: obtaining a component by using a polished member polished by the polishing method according to claim 15.

19. A method for manufacturing a semiconductor component, comprising: obtaining a semiconductor component by using a polished member polished by the polishing method according to claim 15.
